# DEMANDE DE BREVET EUROPEEN

(11) **EP 3 708 384 A1**
(43) Date de publication de la demande: **16.09.2020**
(21) Numéro de dépôt: 19162928.6
(22) Date de dépôt: 14.03.2019
(51) Int. Cl.: B44C 1/22, B44C 3/02, G04D 3/00, G04B 19/12, G04B 37/22, G04B 19/18

(54) **ELEMENT D'HABILLAGE OU CADRAN D'HORLOGERIE OU DE BIJOUTERIE EN MATERIAU CONDUCTEUR**

(71) Demandeur: Omega SA, 2502 Bienne (CH)
(72) Inventeur: JEANRENAUD, Frédéric, 2300 La Chaux-de-Fonds (CH); KISSLING, Gregory, 2520 La Neuveville (CH)
(74) Mandataire: ICB SA

(57) **Abrégé**

Procédé de fabrication d'un composant horloger en matériau conducteur :
- on réalise une embase (1) en matériau conducteur;
- on la recouvre d'une première couche (2) de matériau de protection métallique sacrificielle ;
- on grave un décor en creux (3), mécaniquement ou au moyen d'un laser;
- on recouvre le premier décor en creux (3) et la partie restante de la première couche (2) avec une deuxième couche (4) de matériau de traitement décoratif métallique ou/et coloré;
- on élimine par voie chimique chaque première couche (2) pour obtenir une ébauche (10) comportant un premier décor formé par la partie subsistante de la deuxième couche (4).

## Description

### Domaine de l'invention

L'invention concerne un procédé de fabrication d'un élément d'habillage ou d'un cadran d'horlogerie ou de bijouterie en matériau conducteur.

L'invention concerne encore une montre comportant un élément d'habillage ou/et un cadran réalisé par ce procédé.

L'invention concerne le domaine des composants d'habillage ou d'affichage pour l'horlogerie, et le domaine de la bijouterie.

### Arrière-plan de l'invention

Pour la fabrication de composants bicolores, on connaît un procédé consistant à :
- poser une couche de protection sacrificielle (résine photosensible, vernis, adhésif, film polymère) sur l'ensemble de la surface d'une ébauche ;
- attaquer sélectivement la couche de protection, avec gravure éventuelle du substrat ;
- effectuer un traitement décoratif (galvanoplastie, dépôt sous vide, vernis, laque) ;
- retirer la couche de protection (attaque chimique, dissolution, bombardement ionique, action mécanique).

Hors utilisation de résine photosensible, la définition des contours n'est pas très bonne.

De plus, le matériau de la couche de protection sacrificielle peut présenter un phénomène de dégazage lors d'un passage sous vide ultérieur, notamment pour effectuer le traitement décoratif par métallisation.

Le document JP H05 156425 A au nom de SEIKO EPSON Corp. décrit la formation d'une lettre en creux, ou plus généralement d'un motif, recouvert d'un film coloré, sur la surface d'un matériau de base tel qu'un alliage dur fritté, un alliage de platine ou d'or blanc, de céramique, par un procédé de formation de film sec. La surface du matériau est revêtue d'un film coloré en tant que première couche, un motif en creux ayant une profondeur supérieure à l'épaisseur de la première couche est formé sur la partie concernée par usinage par faisceau laser, le film coloré ayant une composition différente de celle de la première couche est appliqué en tant que deuxième couche par un procédé de formation de film sec, puis la première couche et la deuxième couche, hors de la zone comportant le motif, sont évacuées.

Le document EP 3 067 220 A1 au nom de ROLEX décrit un procédé de décoration d'un élément horloger, avec un gravage profond d'une surface à décorer de l'élément par un laser femtoseconde; et une structuration de surface de cette surface à décorer de l'élément horloger, ces deux décorations étant au moins partiellement superposées l'une à l'autre.

### Résumé de l'invention

L'invention se propose de mettre au point un procédé de fabrication d'un élément d'habillage ou d'un cadran d'horlogerie ou de bijouterie en matériau conducteur, notamment en céramique ou similaire, permettant l'obtention de décors gravés métallisés et/ou colorés.

A cet effet, l'invention concerne un procédé selon la revendication 1.

L'invention concerne encore une montre comportant un élément d'habillage ou/et un cadran réalisé par ce procédé.

Le mode opératoire proposé permet l'obtention de décors de définition élevée sur des substrats conducteurs, tels que céramique, saphir, verre, ou similaire.

De plus, l'invention permet de s'affranchir de l'utilisation de couches de protection organique qui pourraient présenter du dégazage lors d'un passage sous vide ultérieur pour métallisation.

Enfin, la solution présentée ne nécessite pas l'acquisition de matériel de photolithographie onéreux (spin coater, aligneur de masque, salle jaune), et peut être réalisée avec des équipements usuels de gravure mécanique, ou plus particulièrement de gravure laser.

### Description sommaire des dessins

D'autres caractéristiques et avantages de l'invention apparaîtront à la lecture de la description détaillée qui va suivre, en référence aux dessins annexés, où :
- la figure 1 représente, de façon schématisée et en coupe, une séquence opératoire d'un cycle élémentaire du procédé selon l'invention, comportant la réalisation d'une embase, sa couverture avec une première couche de protection métallique sacrificielle, la gravure d'un décor, le dépôt d'une deuxième couche de traitement décoratif métallique ou/et coloré, et l'élimination de la première couche de protection métallique sacrificielle;
- la figure 2 représente, de façon similaire à la figure 1, la seule étape de gravure dans laquelle toutes les gravures atteignent le substrat de l'embase ;
- la figure 3 représente, de façon similaire à la figure 1, une étape facultative d'arasement mécanique de la première couche de protection métallique sacrificielle, et de la deuxième couche de traitement décoratif, avant l'élimination de la première couche de protection métallique sacrificielle;
- la figure 4 représente, de façon similaire à la figure 3, une étape facultative d'arasement mécanique de la deuxième couche de traitement décoratif, après l'élimination de la première couche de protection métallique sacrificielle;
- la figure 5 représente, de façon similaire à la figure 1, la seule étape de dépôt d'une première couche de protection métallique sacrificielle,, avec deux couches superposées de protection métallique sacrificielle ;
- la figure 6 représente, de façon similaire à la figure 1, la seule étape de dépôt d'une deuxième couche de traitement décoratif métallique ou/et coloré, avec deux couches superposées de traitement décoratif ;
- la figure 7 représente un détail de gravure comportant des gravures coniques, seules ou superposées, et des gravures de type pyramidal, seules ou superposées ;

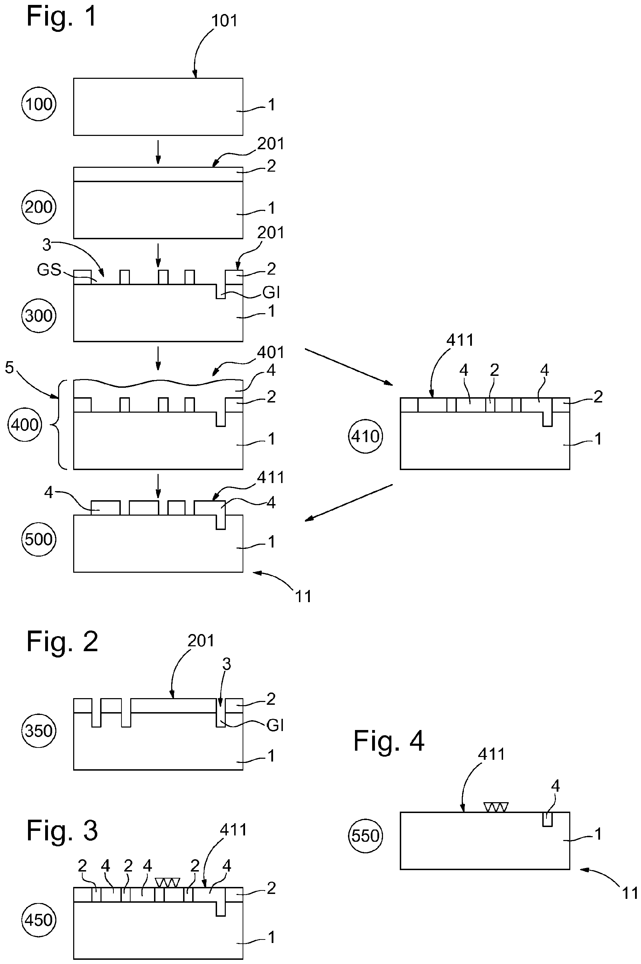

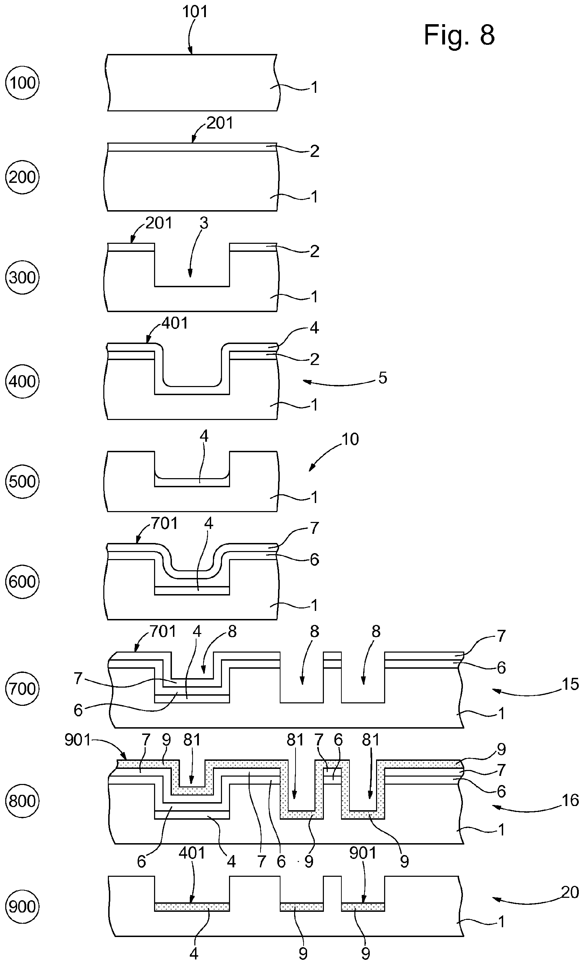

- la figure 8 représente, de façon similaire à la figure 1, une séquence en neuf opérations pour la fabrication d'un composant comportant deux décors différents, où, dans les cinq premières opérations on réalise successivement une ébauche comme dans la figure 1, puis on effectue le recouvrement de cette ébauche, ici dans une variante particulière avec d'abord une couche déposée par vois sèche, puis une couche déposée par voie électrolytique ou galvanique, puis on effectue une deuxième gravure en creux avant de recouvrir le tout d'une couche superficielle, puis d'éliminer les couches de protection métallique sacrificielle pour révéler les décors ;

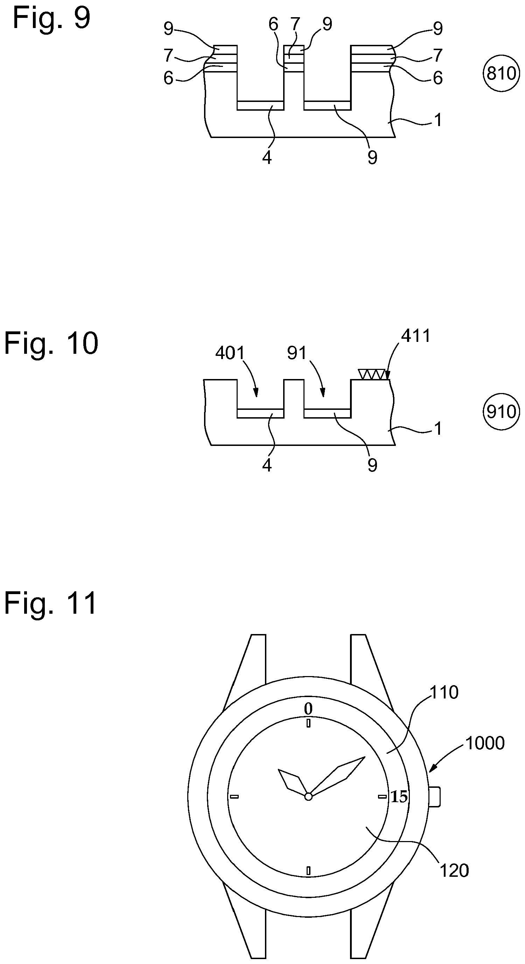

- la figure 9 représente, de façon similaire à la figure 1, une variante de la deuxième gravure en creux de la figure 8, dans laquelle cette gravure est réalisée à bords droits ;
- la figure 10 représente, de façon similaire à la figure 1, une variante de la figure 9 avec un arasage ou un polissage de surface final ;
- la figure 11 représente une montre comportant une lunette et un cadran en céramique réalisés et décorés par le procédé selon l'invention.

### Description détaillée des modes de réalisation préférés

L'invention concerne un procédé de fabrication d'un composant horloger en matériau conducteur, notamment un élément d'habillage ou d'un cadran, selon lequel on effectue au moins une fois un cycle élémentaire comportant, dans cet ordre, les étapes suivantes:
- dans une étape initiale 100 on réalise une embase 1 en un substrat en matériau conducteur, qui est, ou métallique, ou céramique ou organique, ou composite, en définissant un niveau supérieur 101 de l'embase 1 ;
- dans une première opération de recouvrement 200 on recouvre, notamment mais non limitativement par voie sèche, l'embase 1 d'au moins une première couche 2 d'un premier matériau de protection métallique sacrificielle ;
- dans une première opération de gravure 300 on effectue la gravure d'un premier décor en creux 3, avec une profondeur au moins égale à l'épaisseur locale de la première couche 2 de protection métallique sacrificielle, ou mécaniquement ou au moyen d'un laser, ou au moyen d'un laser à impulsion ultracourte, type picolaser ou femtolaser ;
- dans une deuxième opération de recouvrement 400 on recouvre, notamment mais non limitativement par voie sèche, le premier décor en creux 3 et la partie restante de la première couche 2 de protection métallique sacrificielle, avec au moins une deuxième couche 4 d'un deuxième matériau de traitement décoratif métallique ou/et de traitement décoratif coloré, pour réaliser un premier composé intermédiaire 5;
- dans une première opération d'élimination chimique 500 on élimine, notamment par voie chimique, chaque première couche 2 de protection métallique sacrificielle, pour obtenir une première ébauche 10 comportant un premier décor formé par la partie subsistante de la deuxième couche 4, et on réalise le composant horloger soit directement sous forme de la première ébauche 10, ou par un parachèvement de la première ébauche 10.

Plus particulièrement, lors de la première opération de recouvrement 200, on effectue le recouvrement avec une première épaisseur supérieure à 50 nanomètres.

Dans une variante, lors de la première opération de recouvrement 200, on recouvre par voie sèche l'embase 1 d'au moins une première couche 2 de protection métallique sacrificielle. Plus particulièrement, on effectue le premier recouvrement par voie sèche par dépôt PVD OU CVD OU ALD sous vide.

Dans une autre variante, lors de la première opération de recouvrement 200, on recouvre par voie électrolytique ou électrochimique l'embase 1 d'au moins une première couche 2 de protection métallique sacrificielle.

Plus particulièrement, lors de la deuxième opération de recouvrement 400 par au moins une deuxième couche 4 de traitement décoratif métallique ou/et coloré, on effectue le recouvrement avec une deuxième épaisseur comprise entre 50 nanomètres et 1'000 nanomètres.

Dans une variante, lors de la deuxième opération de recouvrement 400, on recouvre par voie sèche l'embase 1 d'au moins une deuxième couche 4 de traitement décoratif métallique ou/et de traitement décoratif coloré. Plus particulièrement, on effectue la deuxième opération de recouvrement 400 par voie sèche par dépôt PVD OU CVD OU ALD sous vide.

Dans une autre variante, lors de la deuxième opération de recouvrement 400, on recouvre par voie électrolytique ou électrochimique l'embase 1 d'au moins une deuxième couche 4 de traitement décoratif métallique ou/et de traitement décoratif coloré.

De façon particulière, lors de l'opération de gravure 300 d'un premier décor en creux 3, on effectue partout la gravure jusque dans le substrat de l'embase 1.

Plus particulièrement, lors de première opération de recouvrement 200, on effectue le premier recouvrement avec une première épaisseur qui est supérieure ou égale à la différence entre, d'une part une deuxième épaisseur d'une deuxième couche 4 de traitement décoratif métallique ou/et coloré à appliquer lors de l'étape 400 de recouvrement du premier décor en creux 3 et de la partie restante de la première couche 2 de protection métallique sacrificielle, et d'autre part la profondeur de gravure dans le substrat de l'embase 1 lors de l'opération de gravure 300 d'un premier décor en creux 3.

Plus particulièrement, lors de l'opération de gravure 300, on effectue la gravure sous forme d'une juxtaposition de cuvettes coniques ou pyramidales profondes.

Plus particulièrement, lors de l'opération de gravure 300, on effectue la gravure avec une profondeur dans l'embase 1 comprise entre 20 nanomètres et l'épaisseur totale de l'embase 1.

Dans une variante, lors de la première opération de recouvrement 200, on effectue le recouvrement au moins partiellement par voie sèche, ou en totalité par voie sèche, avec superposition de plusieurs premières couches 2, 21, 22, de nature différente.

Dans une autre variante, lors de la première opération de recouvrement 200, on effectue le recouvrement au moins partiellement par voie électrolytique ou électrochimique, ou en totalité par voie électrolytique ou électrochimique, avec superposition de plusieurs premières couches 2, 21, 22, de nature différente.

Dans une autre variante encore, on effectue le dépôt de certaines couches par voie sèche, et de certaines autres couches par voie électrolytique ou électrochimique.

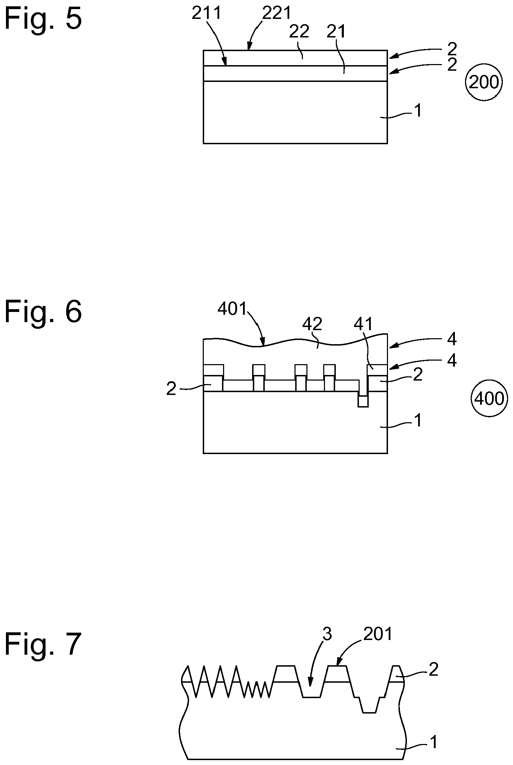

Dans une variante particulière, tel que visible sur la figure 6, lors de l'étape 400 de recouvrement du décor en creux 3 et de la partie restante de ladite première couche 2 de protection métallique sacrificielle, par au moins une deuxième couche 4 de traitement décoratif métallique ou/et coloré, on effectue le recouvrement avec superposition de plusieurs deuxièmes couches 4 de nature différente, 41, 42.

Dans une variante, lors de la deuxième opération de recouvrement 400, on effectue le recouvrement au moins partiellement par voie sèche, ou en totalité par voie sèche, avec superposition de plusieurs deuxièmes couches 4, 41, 42, de nature différente.

Dans une autre variante, lors de la deuxième opération de recouvrement 400, on effectue le recouvrement au moins partiellement par voie électrolytique ou électrochimique, ou en totalité par voie électrolytique ou électrochimique, avec superposition de plusieurs deuxièmes couches 4, 41, 42, de nature différente.

Dans une autre variante encore, on effectue le dépôt de certaines couches par voie sèche, et de certaines autres couches par voie électrolytique ou électrochimique.

Plus particulièrement, on effectue la superposition de plusieurs deuxièmes couches 4, 41, 42, avec au moins une couche de chrome 41 de 50 à 250 nanomètres et une couche d'or 42 de 50 à 150 nanomètres. Plus particulièrement on effectue le dépôt en superposition d'une couche de chrome épaisse d'environ 200 nanomètres, et d'une couche d'or épaisse d'environ 100 nanomètres.

La figure 1 montre une variante 410, moins facile à réaliser, où l'opération 400 est modifiée par un dépôt de la deuxième couche de traitement décoratif au ras de la première couche 2 de protection métallique sacrificielle.

Pour une application particulière de réalisation de cadrans conducteurs gravés métallisés et/ou colorés, une séquence opératoire avantageuse de l'invention comporte des paramètres particuliers :
- 200 : pose d'une couche de protection métallique sacrificielle : de préférence mais non limitativement aluminium, ou chrome, ou cuivre. Cette couche de protection métallique sacrificielle peut être élaborée par voie sèche, plus particulièrement par dépôt PVD, CVD, ALD, ou similaire; elle peut aussi être élaborée par traitement électrolytique ou électrochimique, ou autre.
- 300 : gravure du décor avec un laser, ou avec un laser à impulsion ultracourte, type picolaser ou femtolaser du décor, ou encore avec un nanolaser, voire un attolaser à l'autre extrême, avec ablation sélective de la couche de protection métallique sacrificielle 2, et éventuellement gravure du substrat 1, dite gravure inférieure GI, tel que visible sur les figures;
- 400 : traitement décoratif métallique (or, rhodium, chrome, silicium, ou autre.) ou coloré (oxydes, par exemple dioxyde de silicium, ou corindon, ou autre, nitrures et carbures métalliques ainsi que toute combinaison de leur empilement) élaboré par voie sèche, plus particulièrement PVD, CVD, ALD, ou similaire, ou encore élaboré par traitement électrolytique ou électrochimique, ou autre.;
- 500 : retrait de la couche de protection par voie chimique (solution alcaline type NaOH pour aluminium, mais aussi éventuellement acide pour chrome, ou autre).

Le choix des matériaux est directement défini par les contraintes de la séquence opératoire.

En effet, la nature de chaque couche sacrificielle et celle de chaque couche décorative doivent être choisies de sorte à ce que :
- la solution de décapage permette le retrait de la couche de protection sans altérer le revêtement décoratif ;
- la couche de protection ne soit pas altérée lors de la gravure, notamment lors d'une gravure au laser (notamment mais non limitativement à impulsion ultracourte type picolaser ou femtolaser, mais aussi nanolaser ou autre), en d'autre endroit que dans la zone de gravure définie (altération possible à proximité de la gravure, projection de particules incandescentes) ;
- la couche de protection doit résister aux éventuels nettoyages intermédiaires.

Le choix, lors de l'étape 200, d'une couche de protection sacrificielle métallique évite un dégazage. En effet, cette protection métallique sacrificielle se compose d'un matériau inerte dans les conditions de pression (pouvant descendre jusqu'à P = 1.10⁻⁸ mbar) et de température (typiquement T ≤ 300°C) rencontrées lors du traitement décoratif de l'étape 400, contrairement aux laques/vernis utilisés dans l'art antérieur, qui présentent l'inconvénient, dans ces conditions, de dégazer et/ou se décomposer partiellement, ce qui pouvait perturber la qualité et/ou l'esthétique du traitement décoratif.

De préférence, avant d'effectuer l'étape 200 de recouvrement de l'embase 1 par au moins une première couche 2 de protection métallique sacrificielle, on effectue un nettoyage: lessiviel et/ou solvant, avec/sans ultrasons, avec/sans sollicitation mécanique, avec/sans température, pour assurer la propreté de la surface et ainsi assurer la bonne accroche de la protection métallique sacrificielle.

Dans une variante particulière, lors de l'opération de gravure 300 d'un décor en creux 3, on effectue partout la gravure dans le substrat de l'embase 1, tel que visible sur la figure 2.

Naturellement il convient de nettoyer l'ébauche après l'opération de gravure, avant de procéder au deuxième dépôt de traitement décoratif, notamment par voie PVD OU CVD OU ALD . Ce nettoyage est classique (lessiviel et/ou solvant, avec/sans ultrasons, avec/sans sollicitation mécanique, avec/sans température), mais il ne doit pas altérer la protection métallique sacrificielle. En particulier, dans le cas où la protection métallique sacrificielle comporte de l'aluminium, il faut exclure des solutions de lavage ayant un pH trop basique.

Dans une variante de l'invention, avant ou après l'élimination (en étape 500) par voie chimique de chaque première couche 2 de protection métallique sacrificielle, on arase mécaniquement (dans une étape 550) le composé ainsi réalisé au niveau supérieur de l'embase 1.

Dans une variante particulière, après l'étape de recouvrement 400 où on a recouvert le décor en creux 3 et la partie restante de la première couche 2 de protection métallique sacrificielle avec au moins une deuxième couche 4 de traitement décoratif métallique ou/et coloré, on arase mécaniquement dans une étape 450 le composé ainsi réalisé au niveau supérieur de la première couche 2 de protection métallique sacrificielle.

Dans une autre variante particulière, avant l'élimination 500 par voie chimique de chaque première couche 2 de protection métallique sacrificielle, on arase mécaniquement en étape 550 le composé ainsi réalisé au niveau supérieur de l'embase 1.

Dans une autre variante particulière, après l'élimination 500 par voie chimique de chaque première couche 2 de protection métallique sacrificielle, on arase mécaniquement en étape 550 le composé ainsi réalisé au niveau supérieur de l'embase 1.

Dans une variante, lors de l'étape 200 de recouvrement de l'embase 1 par au moins une première couche 2 de protection métallique sacrificielle, on effectue ce recouvrement par voie sèche par dépôt PVD OU CVD OU ALD sous vide ; différentes méthodes peuvent aussi convenir : évaporation sous vide, pulvérisation sous vide, PECVD, ou autres. Dans une autre variante on effectue ce recouvrement par voie électrolytique ou électrochimique.

Dans une variante particulière, lors de l'étape 200 de recouvrement de l'embase 1 par au moins une première couche 2 de protection métallique sacrificielle, on effectue ce recouvrement avec une première épaisseur supérieure à 50 nanomètres.

Dans une variante avantageuse, lors de l'étape 400 de recouvrement du décor en creux 3 et de la partie restante de la première couche 2 de protection métallique sacrificielle, par au moins une deuxième couche 4 de traitement décoratif métallique ou/et coloré ; on peut effectuer ce recouvrement par voie sèche, notamment par dépôt PVD sous vide (différentes méthodes peuvent convenir : évaporation sous vide, pulvérisation sous vide, CVD, ALD ou autres), ou bien par voie électrolytique ou électrochimique.

Plus particulièrement, lors de l'étape 400 de recouvrement du décor en creux 3 et de la partie restante de la première couche 2 de protection métallique sacrificielle, par au moins une deuxième couche 4 de traitement décoratif métallique ou/et coloré, on effectue ce recouvrement avec une deuxième épaisseur comprise entre 50 nanomètres et 2000 nanomètres, plus particulièrement entre 50 nanomètres et 1000 nanomètres.

De préférence, lors de l'étape 200 de recouvrement de l'embase 1 par au moins une première couche 2 de protection métallique sacrificielle, on effectue le recouvrement avec une première épaisseur qui est supérieure ou égale à la différence entre, d'une part une deuxième épaisseur d'une deuxième couche 4 de traitement décoratif métallique ou/et coloré lors de l'étape 400 de recouvrement du décor en creux 3 et de la partie restante de ladite première couche 2 de protection métallique sacrificielle, et d'autre part la profondeur de gravure dans le substrat de l'embase 1 lors de l'opération de gravure 30 d'un décor en creux 3.

Dans une variante de réalisation avantageuse, lors de l'étape 30 de gravure d'un décor en creux 3, avec une profondeur au moins égale à l'épaisseur locale de la première couche 2 de protection métallique sacrificielle, on effectue la gravure mécaniquement ou au moyen d'un laser, notamment nano-, pico- ou femto-laser.

En alternative de l'invention, on peut, selon un mode opératoire similaire, réaliser cette gravure par différents moyens, seuls ou en combinaison : laser, usinage à l'outil, bombardement ionique, attaque chimique, ou similaires.

Dans une variante particulière, lors de l'étape 300 de gravure d'un décor en creux 3, avec une profondeur au moins égale à l'épaisseur locale de la première couche 2 de protection métallique sacrificielle, on effectue la gravure sous forme d'une juxtaposition de cuvettes coniques ou pyramidales profondes.

Plus particulièrement, on effectue cette gravure 300 avec une profondeur dans l'embase 1 comprise entre 20 nanomètres et l'épaisseur totale de l'embase 1. On peut, ainsi, par exemple, creuser une cuvette conique très profonde sur toute l'épaisseur d'un cadran, par exemple sur une épaisseur de l'ordre du millimètre.

Plus particulièrement, pour d'autres applications, notamment d'affichage, on effectue une gravure laser, sensiblement plate, de 20 µm de profondeur environ.

Dans une autre variante, on effectue une gravure laser plus profonde, par exemple pour définir une cuvette, ou encore un guichet de date biseauté, ou similaire. L'invention permet la réalisation très fine d'un tel guichet biseauté bicolore, excessivement difficile à réaliser par d'autres moyens.

Dans une variante particulière, tel que visible sur la figure 5, lors de l'étape 200 de recouvrement de l'embase 1 par au moins une première couche 2 de protection métallique sacrificielle, on effectue le recouvrement avec superposition de plusieurs premières couches 2 de nature différente 21, 22.

Le choix des matériaux utilisable est assez large :
- pour le substrat conducteur on peut utiliser en particulier: céramique, saphir, verre, verre organique, plastique, émail, matériau au moins partiellement amorphe :
- pour la protection métallique sacrificielle, par exemple de l'aluminium ou du chrome:
   ∘ pour une protection métallique sacrificielle comportant de l'aluminium, un traitement décoratif peut comporter : Au, Cr, Rh, Ti, Si, et/ou alliages et/ou oxydes et/ou nitrures et/ou carbures et/ou combinaisons de ces métaux ;
   ∘ pour une protection métallique sacrificielle comportant du chrome, un traitement décoratif peut comporter : Au, Rh, Ti, Si, et/ou alliages et/ou oxydes et/ou nitrures et/ou carbures et/ou combinaisons de ces métaux.

Dans une variante, après la première opération d'élimination chimique 500, dans une troisième opération de recouvrement 600 on recouvre, par un procédé galvanique, la première ébauche 10 d'au moins une couche superficielle 7 du premier matériau de protection métallique sacrificielle ou d'un autre matériau de protection métallique sacrificielle. Le procédé galvanique nécessite toutefois d'être appliqué sur un substrat conducteur.

Dans une autre variante, après la première opération d'élimination chimique 500, dans une troisième opération de recouvrement 600 on recouvre par voie sèche, plus particulièrement par dépôt PVD, CVD, ALD, ou similaire, la première ébauche 10 d'au moins une troisième couche 6 du premier matériau de protection métallique sacrificielle, ou d'un autre matériau de protection métallique sacrificielle. Ce mode de recouvrement est indépendant de la nature du substrat.

Dans une autre variante encore, lors de l'opération de recouvrement 600, après avoir créé une telle troisième couche 6, on recouvre ensuite, par un procédé galvanique, la troisième couche 6 par au moins une couche superficielle 7 du premier matériau de protection métallique sacrificielle, ou du matériau de protection métallique sacrificielle de la troisième couche 6, ou d'un autre matériau de protection métallique sacrificielle. Le choix d'une troisième couche 6 conductrice permet l'application du procédé galvanique de constitution de la couche superficielle 7. Rien n'empêche que le matériau de la troisième couche 6 soit le même que celui de la couche superficielle 7, par exemple du cuivre.

Plus particulièrement, on effectue, après la troisième opération de recouvrement 600, une deuxième opération de gravure 700 dans laquelle on effectue, mécaniquement ou au moyen d'un laser, la gravure d'un deuxième décor en creux 8, avec une profondeur au moins égale à l'épaisseur cumulée des couches déposées lors de la troisième opération de recouvrement 600, sur la première ébauche 10, pour réaliser un deuxième composé intermédiaire 15.

Plus particulièrement encore, on effectue, après cette deuxième opération de gravure 700, une quatrième opération de recouvrement 800, lors de laquelle on recouvre le deuxième décor en creux 8 et la surface la plus externe du deuxième composé intermédiaire 15, avec au moins une cinquième couche 9 d'un cinquième matériau de traitement décoratif métallique ou/et de traitement décoratif coloré, pour obtenir un troisième composé intermédiaire 16.

Plus particulièrement encore, on effectue, après cette quatrième opération de recouvrement 800, une deuxième opération d'élimination chimique 900, par laquelle on élimine par voie chimique chaque couche de protection métallique sacrificielle, pour obtenir une deuxième ébauche 20 comportant le premier décor formé par la partie subsistante de la deuxième couche 4, et un deuxième décor formé par la partie subsistante de la cinquième couche 9, et on réalise le composant horloger soit directement sous forme de cette deuxième ébauche 20, ou par un parachèvement de cette deuxième ébauche 20.

Plus particulièrement, on choisit au moins un sixième matériau de traitement décoratif métallique ou/et de traitement décoratif coloré, et en on réitère, pour la réalisation de l'ébauche, avec les mêmes matériaux de protection métallique sacrificielle ou d'autres matériaux de protection métallique sacrificielle analogues, la séquence combinant la troisième opération de recouvrement 600, la deuxième opération de gravure 700, la quatrième opération de recouvrement 800, et la deuxième opération d'élimination chimique 900, pour la réalisation d'au moins un autre décor se rajoutant au premier décor et au deuxième décor.

Plus particulièrement, on effectue, après la quatrième opération de recouvrement 800 et avant la deuxième opération d'élimination chimique 900, une opération de gravure intermédiaire 810 lors de laquelle on effectue, mécaniquement ou au moyen d'un laser, la gravure d'un troisième décor en creux 81.

Plus particulièrement, avant ou après une opération d'élimination chimique d'une couche de protection métallique sacrificielle, on effectue une opération d'arasage mécanique 550 ou 910, lors de laquelle on arase mécaniquement le composé ainsi réalisé au niveau supérieur 101 de l'embase 1, ou sous ce niveau supérieur 101, pour réaliser une surface d'aspect au niveau supérieur 411 de la partie subsistante du composant. Plus particulièrement, après l'achèvement du premier cycle élémentaire et un nettoyage, on exécute au moins un autre cycle élémentaire avec des paramètres modifiés pour l'opération de gravure et/ou pour le choix du traitement décoratif.

L'invention se prête particulièrement bien au cas préféré où, lors de l'étape de réalisation 100 de l'embase 1, on utilise un substrat en céramique.

Plus particulièrement, on utilise au moins un matériau de protection métallique sacrificielle qui est du cuivre ou de l'aluminium ou de l'or ou du platine.

Plus particulièrement, on fabrique le composant horloger pour former un élément d'habillage ou un cadran.

Ainsi, plus particulièrement, le procédé selon l'invention est bien adapté à la fabrication d'un élément d'habillage tel qu'une boîte, une lunette, un rehaut, ou d'un cadran d'horlogerie ou de bijouterie, ou encore d'un composant de bijouterie, par exemple un élément de bracelet ou de bijou, en matériau conducteur, notamment en céramique ou similaire, permettant l'obtention de décors gravés métallisés et/ou colorés.

L'invention permet de réaliser des composants bicolores ou multicolores.

En effet, on peut effectuer une itération du procédé, avec des décors gravés différents, ou/et des traitements décoratifs différents.

Ainsi, après l'exécution de la phase 500 et achèvement d'un premier cycle élémentaire, et après un nettoyage, on peut exécuter au moins un autre cycle élémentaire avec des paramètres modifiés pour l'opération de gravure et/ou pour le choix du traitement décoratif.

Il est donc possible, sans limitation du nombre d'itérations, de recommencer, avec des paramètres modifiés, toute la séquence opératoire du cycle élémentaire avec :
- dépôt de protection métallique sacrificielle ;
- gravure d'un autre décor, par exemple ailleurs sur le substrat et/ou partiellement sur une gravure déjà réalisée dans une phase antérieure;
- dépôt d'un autre traitement décoratif ;
- dissolution de la protection métallique sacrificielle.

Ce cycle peut être refait plusieurs fois pour obtenir des composants multicolores, présentant par exemple des parties d'aspect différent en Au, Ti, Si, Rh, ou autres.

Une texture particulière de la gravure peut, aussi, permettre d'obtenir un aspect visuel particulier, selon la rugosité, la densité et la profondeur de gravure, qui déterminent des reflets ou un rendu particulier du traitement décoratif appliqué, par exemple satiné, semi-mat, brillant, ou autre.

L'invention concerne encore une montre 1000, qui comporte un élément d'habillage 110, tel que lunette, boîte, ou similaire, notamment en céramique, ou/et qui comporte un cadran 120, notamment en céramique, réalisé par le procédé selon l'invention.

Ce mode opératoire permet de s'affranchir de l'utilisation d'équipements coûteux de photolithographie pour obtenir des décors de très bonne définition.

De plus, l'utilisation d'une couche de protection sacrificielle métallique permet d'éviter tout dégazage problématique lors du traitement sous vide préféré pour l'application de la couche de traitement décoratif métallique et/ou coloré.

L'invention se prête bien à la décoration de cadrans conducteurs (céramique, émail, saphir, plastique, ou autre), de glaces (verre, saphir, ou autre), de composants en matière plastique, de boîtiers de montre, carrures, lunettes, couronnes, et autre. La qualité, la finesse et le contraste des décors, qui peuvent être réalisés en métaux précieux, autorisent une décoration de grande finesse compatible avec l'horlogerie de luxe, et notamment la décoration d'éléments de complications, comme par exemple des indicateurs de phase de lune à haute résolution. Le coût raisonnable de la mise en oeuvre du procédé autorise aussi son utilisation pour des composants d'horlogerie ou de bijouterie de plus grande diffusion.

Naturellement, l'invention est avantageuse, non seulement pour des composants d'horlogerie ou de bijouterie, mais aussi pour des bijoux ou des composants de bijouterie, voire de lunetterie ou d'articles de mode.

En effet, l'invention permet de modifier, et d'enrichir sensiblement l'aspect de composants directement visibles par l'utilisateur, avec des décors innovants, et participe à la promotion de la marque et du produit. Plus particulièrement, l'invention est utilisable pour des marquages d'identification et/ou des marquages anti-contrefaçon.

## Revendications

1. Procédé de fabrication d'un composant horloger en matériau conducteur, notamment un élément d'habillage ou d'un cadran, **caractérisé en ce qu'**on effectue au moins une fois un cycle élémentaire comportant, dans cet ordre, les étapes suivantes :
- dans une étape initiale (100) on réalise une embase (1) en un substrat en matériau conducteur, qui est, ou métallique, ou céramique ou organique, ou composite, en définissant un niveau supérieur (101) de ladite embase (1) ;
- dans une première opération de recouvrement (200) on recouvre ladite embase (1) d'au moins une première couche (2) d'un premier matériau de protection métallique sacrificielle ;
- dans une première opération de gravure (300) on effectue la gravure d'un premier décor en creux (3), avec une profondeur au moins égale à l'épaisseur locale de ladite première couche (2) de protection métallique sacrificielle, mécaniquement ou au moyen d'un laser, ou au moyen d'un laser à impulsion ultracourte, type picolaser ou femtolaser ;
- dans une deuxième opération de recouvrement (400) on recouvre ledit premier décor en creux (3) et la partie restante de ladite première couche (2) de protection métallique sacrificielle, avec au moins une deuxième couche (4) d'un deuxième matériau de traitement décoratif métallique ou/et de traitement décoratif coloré, pour réaliser un premier composé intermédiaire (5);
- dans une première opération d'élimination chimique (500) on élimine par voie chimique chaque dite première couche (2) de protection métallique sacrificielle, pour obtenir une première ébauche (10) comportant un premier décor formé par la partie subsistante de ladite deuxième couche (4), et **en ce qu'**on réalise ledit composant horloger soit directement sous forme de ladite première ébauche (10), ou par un parachèvement de ladite première ébauche (10).

2. Procédé selon la revendication 1, **caractérisé en ce que**, lors de ladite première opération de recouvrement (200), on effectue ledit recouvrement avec une première épaisseur supérieure à 50 nanomètres.

3. Procédé selon la revendication 1 ou 2, **caractérisé en ce que**, lors de ladite première opération de recouvrement (200), on recouvre par voie sèche ladite embase (1) d'au moins une dite première couche (2) de protection métallique sacrificielle.

4. Procédé selon la revendication 3, **caractérisé en ce qu'**on effectue ledit premier recouvrement par voie sèche par dépôt PVD OU CVD OU ALD sous vide.

5. Procédé selon la revendication 1 ou 2, **caractérisé en ce que**, lors de ladite première opération de recouvrement (200), on recouvre par voie électrolytique ou électrochimique ladite embase (1) d'au moins une dite première couche (2) de protection métallique sacrificielle.

6. Procédé selon l'une des revendications 1 à 5, **caractérisé en ce que**, lors de ladite deuxième opération de recouvrement (400) par au moins une deuxième couche (4) de traitement décoratif métallique ou/et coloré, on effectue ledit recouvrement avec une deuxième épaisseur comprise entre 50 nanomètres et 1'000 nanomètres.

7. Procédé selon l'une des revendications 1 à 6, **caractérisé en ce que**, lors de ladite deuxième opération de recouvrement (400), on recouvre par voie sèche ladite embase (1) d'au moins une dite deuxième couche (4) de traitement décoratif métallique ou/et de traitement décoratif coloré.

8. Procédé selon la revendication 7, **caractérisé en ce qu'**on effectue ladite deuxième opération de recouvrement (400) par voie sèche par dépôt PVD OU CVD OU ALD sous vide.

9. Procédé selon l'une des revendications 1 à 6, **caractérisé en ce que**, lors de ladite deuxième opération de recouvrement (400), on recouvre par voie électrolytique ou électrochimique ladite embase (1) d'au moins une dite deuxième couche (4) de traitement décoratif métallique ou/et de traitement décoratif coloré.

10. Procédé selon l'une des revendications 1 à 9, **caractérisé en ce que**, lors de ladite opération de gravure (300) d'un dit premier décor en creux (3), on effectue partout ladite gravure jusque dans ledit substrat de ladite embase (1).

11. Procédé selon l'une des revendications 1 à 10, **caractérisé en ce que**, lors de première opération de recouvrement (200), on effectue ledit premier recouvrement avec une première épaisseur qui est supérieure ou égale à la différence entre, d'une part une deuxième épaisseur d'une deuxième couche (4) de traitement décoratif métallique ou/et coloré à appliquer lors de l'étape (400) de recouvrement dudit premier décor en creux (3) et de ladite partie restante de ladite première couche (2) de protection métallique sacrificielle, et d'autre part la profondeur de gravure dans le substrat de ladite embase (1) lors de ladite opération de gravure (300) d'un dit premier décor en creux (3).

12. Procédé selon l'une des revendications 1 à 11, **caractérisé en ce que**, lors de ladite opération de gravure (300), on effectue ladite gravure sous forme d'une juxtaposition de cuvettes coniques ou pyramidales profondes.

13. Procédé selon l'une des revendications 1 à 12, **caractérisé en ce que** lors de ladite opération de gravure (300), on effectue ladite gravure avec une profondeur dans ladite embase (1) comprise entre 20 nanomètres et l'épaisseur totale de ladite embase (1).

14. Procédé selon l'une des revendications 1 à 13, **caractérisé en ce que**, lors de ladite première opération de recouvrement (200), on effectue ledit recouvrement au moins partiellement par voie sèche, ou en totalité par voie sèche, avec superposition de plusieurs dites premières couches (2 ; 21 ; 22) de nature différente.

15. Procédé selon l'une des revendications 1 à 13, **caractérisé en ce que**, lors de ladite première opération de recouvrement (200), on effectue ledit recouvrement au moins partiellement par voie électrolytique ou électrochimique, ou en totalité par voie électrolytique ou électrochimique, avec superposition de plusieurs dites premières couches (2 ; 21 ; 22) de nature différente.

16. Procédé selon l'une des revendications 1 à 15, **caractérisé en ce que**, lors de ladite deuxième opération de recouvrement (400), on effectue ledit recouvrement au moins partiellement par voie sèche, ou en totalité par voie sèche, avec superposition de plusieurs dites deuxièmes couches (4 ; 41 ; 42) de nature différente.

17. Procédé selon l'une des revendications 1 à 15, **caractérisé en ce que**, lors de ladite deuxième opération de recouvrement (400), on effectue ledit recouvrement au moins partiellement par voie électrolytique ou électrochimique, ou en totalité par voie électrolytique ou électrochimique, avec superposition de plusieurs dites deuxièmes couches (4 ; 41 ; 42) de nature différente.

18. Procédé selon la revendication 16 ou 17, **caractérisé en ce qu'**on effectue ladite superposition de plusieurs dites deuxièmes couches (4 ; 41 ; 42) avec au moins une couche de chrome (41) de 50 à 250 nanomètres et une couche d'or (42) de 50 à 150 nanomètres.

19. Procédé selon l'une des revendications 1 à 14, **caractérisé en ce que**, après ladite première opération d'élimination chimique (500), dans une troisième opération de recouvrement (600) on recouvre, par un procédé galvanique, ladite première ébauche (10) d'au moins une couche superficielle (7) dudit premier matériau de protection métallique sacrificielle ou d'un autre matériau de protection métallique sacrificielle.

20. Procédé selon l'une des revendications 1 à 14, **caractérisé en ce que**, après ladite première opération d'élimination chimique (500), dans une troisième opération de recouvrement (600) on recouvre, par voie sèche, ladite première ébauche (10) d'au moins une troisième couche (6) dudit premier matériau de protection métallique sacrificielle ou d'un autre matériau de protection métallique sacrificielle.

21. Procédé selon la revendication 20, **caractérisé en ce que**, lors de ladite opération de recouvrement (600), après avoir créé ladite troisième couche (6), on recouvre ensuite, par un procédé galvanique, ladite troisième couche (6) par au moins une couche superficielle (7) dudit premier matériau de protection métallique sacrificielle ou du matériau de protection métallique sacrificielle de ladite troisième couche (6), ou d'un autre matériau de protection métallique sacrificielle.

22. Procédé selon l'une des revendications 19 à 21, **caractérisé en ce qu'**on effectue, après ladite troisième opération de recouvrement (600), une deuxième opération de gravure (700) dans laquelle on effectue, mécaniquement ou au moyen d'un laser, la gravure d'un deuxième décor en creux (8), avec une profondeur au moins égale à l'épaisseur cumulée des couches déposées lors de ladite troisième opération de recouvrement (600), sur ladite première ébauche (10), pour réaliser un deuxième composé intermédiaire (15).

23. Procédé selon la revendication 22, **caractérisé en ce qu'**on effectue, après ladite deuxième opération de gravure (700), une quatrième opération de recouvrement (800), lors de laquelle on recouvre ledit deuxième décor en creux (8) et la surface la plus externe dudit deuxième composé intermédiaire (15), avec au moins une cinquième couche (9) d'un cinquième matériau de traitement décoratif métallique ou/et de traitement décoratif coloré.

24. Procédé selon la revendication 23, **caractérisé en ce qu'**on effectue, après ladite quatrième opération de recouvrement (800), une deuxième opération d'élimination chimique (900) par laquelle on élimine par voie chimique chaque couche de protection métallique sacrificielle, pour obtenir une deuxième ébauche (20) comportant ledit premier décor formé par la partie subsistante de ladite deuxième couche (4), et un deuxième décor formé par la partie subsistante de ladite cinquième couche (9), et **en ce qu'**on réalise ledit composant horloger soit directement sous forme de ladite deuxième ébauche (20), ou par un parachèvement de ladite deuxième ébauche (20).

25. Procédé selon la revendication 24, **caractérisé en ce qu'**on choisit au moins un sixième matériau de traitement décoratif métallique ou/et de traitement décoratif coloré, et en qu'on réitère, pour sa réalisation, avec les mêmes matériaux de protection métallique sacrificielle ou d'autres matériaux de protection métallique sacrificielle analogues, la séquence combinant ladite troisième opération de recouvrement (600), ladite deuxième opération de gravure (700), ladite quatrième opération de recouvrement (800), et ladite deuxième opération d'élimination chimique (900), pour la réalisation d'au moins un autre décor se rajoutant audit premier décor et audit deuxième décor.

26. Procédé selon la revendication 24 ou 25, **caractérisé en ce qu'**on effectue, après ladite quatrième opération de recouvrement (800) et avant ladite deuxième opération d'élimination chimique (900), une opération de gravure intermédiaire (810) lors de laquelle on effectue, mécaniquement ou au moyen d'un laser, la gravure d'un troisième décor en creux (81).

27. Procédé selon l'une des revendications 1 à 26, **caractérisé en ce que**, avant ou après une opération d'élimination chimique d'une couche de protection métallique sacrificielle, on effectue une opération d'arasage mécanique (550 ; 910) lors de laquelle on arase mécaniquement le composé ainsi réalisé audit niveau supérieur (101) de ladite embase (1) ou sous ledit niveau supérieur (101) pour réaliser une surface d'aspect au niveau supérieur (411) de la partie subsistante dudit composant.

28. Procédé selon l'une des revendications 1 à 27, **caractérisé en ce que**, après l'achèvement du premier dit cycle élémentaire et un nettoyage, on exécute au moins un autre dit cycle élémentaire avec des paramètres modifiés pour ladite opération de gravure et/ou pour le choix dudit traitement décoratif.

29. Procédé selon l'une des revendications 1 à 28, **caractérisé en ce que**, lors de l'étape de réalisation (100) de ladite embase (1), on utilise un substrat en céramique.

30. Procédé selon l'une des revendications 1 à 29, **caractérisé en ce qu'**on utilise au moins un matériau de protection métallique sacrificielle qui est du cuivre ou de l'aluminium ou de l'or ou du platine.

31. Procédé selon l'une des revendications 1 à 30, **caractérisé en ce qu'**on fabrique ledit composant horloger pour former un élément d'habillage ou un cadran.

32. Montre (1000) comportant au moins un composant horloger réalisé par le procédé selon l'une des revendications 1 à 31.
